# EUROPEAN PATENT APPLICATION

(11) **EP 2 846 617 A1**
(43) Date of publication of application: **11.03.2015**
(21) Application number: 13183557.1
(22) Date of filing: 09.09.2013
(51) Int. Cl.: H05K 7/20, E21B 47/01

(54) **Cooling arrangement for power electronics building blocks**

(71) Applicant: ABB Technology Ltd, 8050 Zürich (CH)
(72) Inventor: Spindler, Christian, CH-8707 Uetikon am See (CH); Bjornstad, Eiril, NO-0468 Oslo (NO); Kolstad, Helge, 0586 Oslo (NO); Grinberg, Roman, CH-8051 Zurich (CH)
(74) Representative: Savela, Reino Aleksi

(57) **Abstract**

There is presented an arrangement for cooling power electronics building blocks, PEBBs. Each PEBB comprises a semiconductor module. The arrangement comprises a first vertical level comprising N1 PEBBs. The arrangement comprises a second vertical level comprising N₂ PEBBs, where N2>N1. Thermal driven circulation generated by the PEBBs causes a cooling liquid to flow along a liquid flow path in a direction to first cool the PEBBs of the first vertical level and then to cool the PEBBs of the second vertical level. This provides uneven temperature distribution of the cooling liquid and thus uneven cooling of the PEBBs.

## Description

### TECHNICAL FIELD

The invention relates to cooling arrangements, and particularly to arrangements for cooling power electronics building blocks.

### BACKGROUND

Electric subsea installations and devices usually demand high standards regarding durability, long-term functionality and independence during operation. Electric subsea installations that need to be cooled during operation, such as subsea converters, require an autonomous and durable cooling of its components. It is known to use a dielectric liquid such as a for example oil as a cooling fluid. In general, electric subsea installations need to be pressurized with the dielectric fluid, thus said fluid, which is preferably a liquid, should be, at least almost, incompressible. In general terms, the dielectric liquid thus is used to provide an incompressible medium and additionally as an electric insulation medium of components, such as power electronics building blocks, placed in the electric installation.

In such subsea applications, the ambient hydrostatic pressure increases by 1 bar each 10 m of water depth. Two basic technological concepts foresee either the installation of a thick-walled container comprising the electric subsea installations and devices, keeping the interior pressure at 1 bar in order to protect sensitive electronics of the electric subsea installations and devices. A second concept foresees the installation of a thin-walled container comprising the electric subsea installations and devices and being filled with an insulating, incompressible liquid which automatically takes on the ambient hydrostatic pressure, thus requiring adaption of sensitive parts inside the container.

One challenge is the cooling of power electronics building blocks (PEBBs) inside the subsea container. On the one hand, the liquid environment favors cooling due to better heat transfer between hot PEBBs and the liquid. The contact of the dielectric liquid to a hot PEBB will heat up the liquid locally and create a pressure difference with respect to the surrounding liquid that drives natural convection. On the other hand, cooling could be much enhanced by applying forced convection, i.e., creating an artificial flow of the dielectric liquid and thus a more rapid exchange of heated liquid with fresh, cool liquid. Such forced convection is conventionally realized with a pumping system. In the subsea container however, it is not desirable to employ any type of complex auxiliary systems including pumps, because they inherently reduce the reliability of the total system where long-term, maintenance-free operation is a desirable quality.

Hence there is still a need for improved cooling of PEBBs in subsea applications.

### SUMMARY

An object of embodiments herein is to provide improved mechanisms for cooling of PEBBs in subsea applications.

The inventors of the enclosed embodiments have through a combination of practical experimentation and theoretical derivation discovered that current mechanisms for cooling PEBBs in subsea applications result in uneven temperatures of the PEBBs.

A particular object is therefore to provide improved mechanisms for cooling PEBBs in subsea applications whilst avoiding uneven temperatures of the PEBBs.

The present invention addresses this by means of appropriate geometric arrangement of the PEBBs. Particularly, according to a first aspect there is presented an arrangement for cooling power electronics building blocks, PEBBs, wherein each PEBB comprises a semiconductor module. The arrangement comprises a first vertical level comprising N1 PEBBs; The arrangement comprises a second vertical level comprising N2 PEBBs, where N2>N1. The arrangement comprises a cooling liquid. Thermal driven circulation generated by the PEBBs causes the cooling liquid to flow along a liquid flow path in a direction to first cool the PEBBs of the first vertical level and then to cool the PEBBs of the second vertical level, thereby providing uneven temperature distribution of the cooling liquid and uneven cooling of the PEBBs. Each PEBB may comprise at least one power semiconductor module.

Advantageously, the proposed arrangement may enable to extend life time of the PEBBs inside the arrangement and to achieve desired PEBB lifetime without having to dimension the PEBBs for worst case position inside the arrangement with respect to cooling.

According to a second aspect there is presented a subsea power conversion unit. The subsea power conversion unit comprises an arrangement according to the first aspect. According to one aspect there may thus be proposed an electrical system which may be contained in a water tight vessel filled with cooling liquid where cooling of internal PEBB modules are achieved by a thermal driven circulation of the cooling liquid, resulting in an uneven temperature distribution inside the water tight vessel and uneven cooling of the PEBB modules.

Advantageously, the uneven temperature distribution of the cooling liquid could be compensated for by utilizing unit control freedoms to "move" losses from PEBB modules with poor cooling to PEBB modules with better cooling.

Advantageously, any kind of geometric arrangement, which falls within the scope of the independent claims, of PEBB modules could be used to equalize the cooling performance.

Advantageously, the arrangement could comprise any kind of further heat dissipating elements in the space not occupied by the PEBBs to further improve the volume efficiency of the arrangement and to help establishing a stable natural convective cooling flow.

Advantageously, the flow of the cooling liquid may be increased by arranging local geometric changes in the flow path in order to (improve or) compensate for reduced cooling performance due to an increased temperature of the cooling liquid.

Advantageously, the heat transfer from the PEBBs to the cooling liquid may be further improved by providing the PEBBs with heat-sinks which may comprise flow breakers or channels.

According to a third aspect there is presented a method for cooling power electronics building blocks, PEBBs, wherein each PEBB comprises a semiconductor module. The method comprises providing a first vertical level comprising N1 PEBBs. The method comprises providing a second vertical level comprising N2 PEBBs, where N2>N1. The method comprises cooling the PEBBs by providing a cooling liquid, wherein thermal driven circulation generated by the PEBBs causes the cooling liquid to flow along a liquid flow path in a direction passing the PEBBs of the first vertical level before the PEBBs of the second vertical level, thereby providing uneven temperature distribution of the cooling liquid and uneven cooling of the PEBBs. Each PEBB may comprise at least one power semiconductor module.

It is to be noted that any feature of the first, second and third aspects may be applied to any other aspect, wherever appropriate. Likewise, any advantage of the first aspect may equally apply to the second, and/or third aspect, respectively, and vice versa. Other objectives, features and advantages of the enclosed embodiments will be apparent from the following detailed disclosure, from the attached dependent claims as well as from the drawings.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated.

### BRIEF DESCRIPTION OF THE DRAWINGS

The invention is now described, by way of example, with reference to the accompanying drawings, in which:
Figures 1 to 6 schematically illustrate arrangements for cooling power electronics building blocks; and

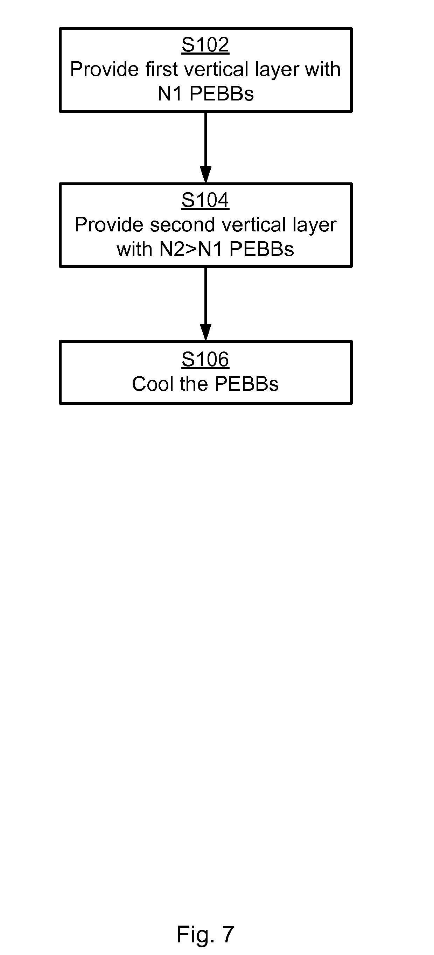

Figure 7 is a flow chart illustrating a method according to an embodiment.

### DETAILED DESCRIPTION

The invention will now be described more fully hereinafter with reference to the accompanying drawings, in which certain embodiments of the invention are shown. This invention may, however, be embodied in many different forms and should not be construed as limited to the embodiments set forth herein; rather, these embodiments are provided by way of example so that this disclosure will be thorough and complete, and will fully convey the scope of the invention to those skilled in the art. Like numbers refer to like elements throughout the description.

Cooling systems for electric equipment, and specifically for electric subsea converters, are used to cool down electric components, such as semiconductor modules, connectors and capacitors. These components generate heat that needs to be dissipated by the cooling system. The cooling system of subsea converters are usually designed in a simple manner avoiding any unnecessary parts and mechanisms. Generally it is desirable to have passive cooling systems, thus cooling systems without any driven or powered parts, such as for example without pumps, to cool down the electric components. In some cases natural convection is used. Natural convection helps to avoid the use of a pump but it has a low efficiency. Cooling by natural convection uses the heat exchange between the cooling liquid and the surrounding sea water to generate circulation within the cooling system and thus within the electric installation and the subsea converter, respectively. Usually some kind of a heat exchanger is used to exchange heat between the sea water and the cooling liquid.

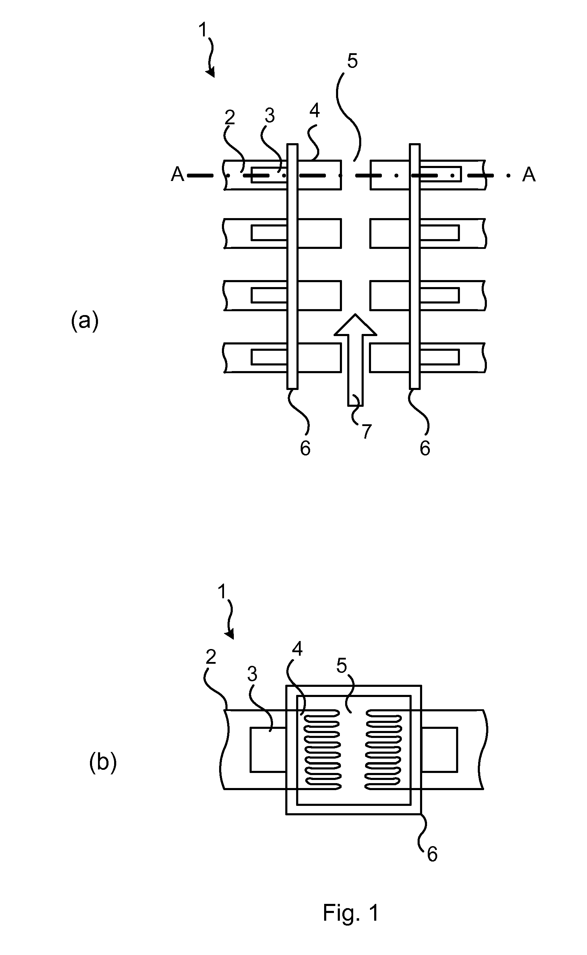

Efficient cooling of electrical and/or electronic circuits typically enables equipment size to be reduced or a lower operating temperature to be achieved, thus yielding increased lifetime. For maximum reliability of the cooling system, passive, natural convective cooling is preferred over forced cooling. Current approaches in this context describe construction of a chamber, i.e. a hollow fluid guide in the center of a liquid-filled subsea vessel. Figure 1(a) schematically illustrates a sectional view of an arrangement 1 for cooling PEBBs. Figure 1(b) schematically illustrates a top view of the same arrangement taken along the section A-A in Figure 1(a). The arrangement 1 comprises PEBBs 2 arranged at vertical levels. Each PEBB 2 comprises a semiconductor module 3 and a heat-sink 4. The dominant heat sources (i.e., the PEBBs) are arranged around a chamber 5 vertically enclosed by walls 6 and thus transfer their dissipation heat to a cooling liquid. The density of the cooling liquid decreases with increasing temperature, thus causing a drag of liquid through the chamber. The flow of the cooling liquid as well as the cooling liquid itself is in Figure 1(a) schematically illustrated by arrow 7.

Calculations have shown that this is a reliable and robust arrangement from a cooling perspective. However, further construction effort may be needed regarding the reliability of the PEBBs. In the chamber arrangement thus described the cooling liquid temperature inside the chamber 15 will be lowest at the bottom and hottest at the top, due to the quasi-continuous heating of the liquid through the vertically distributed heat sources. If the operation conditions of the PEBBs (such as, but not limited to, switching frequency and on-state current) are the same for all PEBBs, the heat production will be equal along the chamber. Due to the different liquid temperatures, the cooling will thus be more efficient at the bottom of the chamber and less efficient at the top. Thus, aging of the PEBBs will be fastest at the top of the chamber and there is hence a higher risk of failing PEBBs at the top. If all PEBBs are constructed according the same principles, the PEBBs will have to be constructed for the less efficient cooling situation.

In subsea units, cooling of internal modules, such as PEBBs, can thus be achieved by providing a thermal driven circulation cooling liquid inside the unit, see Figure 1(a) and 1(b). As noted above, inside the arrangement, there will be temperature gradients in the cooling liquid, where thus the cooling liquid in the upper part of the arrangement is likely to have the highest temperature.

The herein provided mechanisms for compensating for the effect of uneven cooling of PEBBs inside a liquid filled subsea unit are based on using a thermal driven circulation based passive cooling system. The mechanisms make use of utilizing unit control freedoms to "move" losses from PEBBs with poor cooling due to higher liquid temperature to PEBBs with better cooling due to colder liquid.

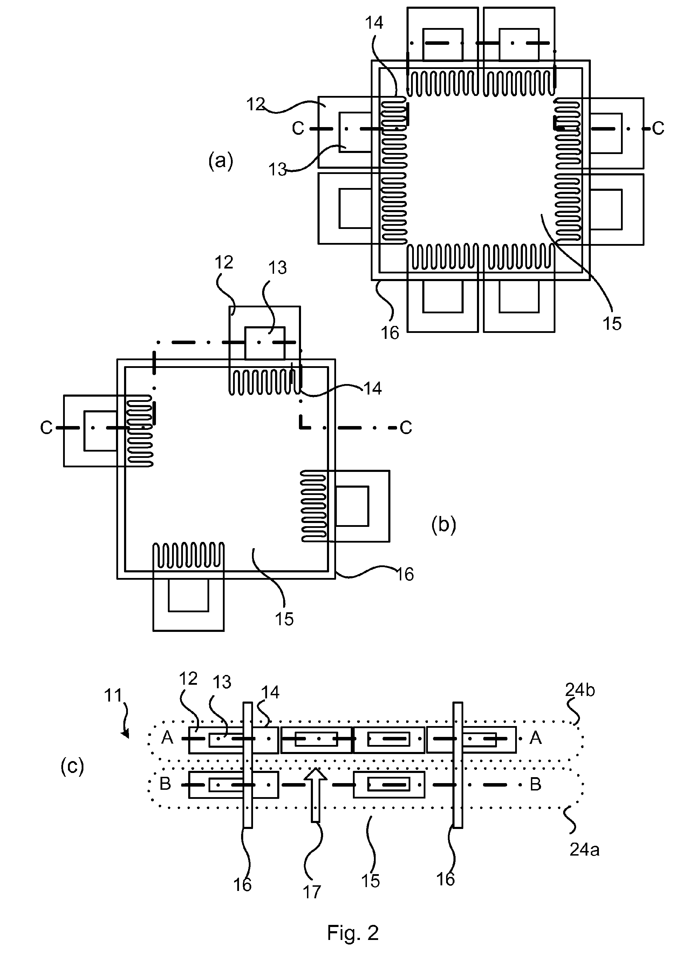

Figures 2(a), 2(b), and 2(c) schematically illustrate different views of an arrangement 11 for cooling power electronics building blocks (PEBBs) 12 where each PEBB 12 comprises a semiconductor module 13. Each PEBB 12 may comprise at least one power semiconductor module. The arrangement 11 may be part of a subsea power conversion unit 23. The arrangement 11 comprises a first vertical level 24a comprising N1 PEBBs. A method for cooling PEBBs comprises providing (in a step S102) the first vertical layer. In the sectional view of Figure 2(c) the first vertical level is defined by the section taken along the line B-B, a top view of which is schematically illustrated in Figure 2(b) which also shows the section C-C at which the sectional view of Figure 2(c) is illustrated. In the illustrative example of Figures 2(a)-(c), N1=4 (assuming that there are four sides per vertical level, and on the first vertical level one PEBB is provided on each side). The arrangement comprises a second vertical level 24b comprising N2 PEBBs, where N2>N1. A method for cooling PEBBs comprises providing (in a step S104) the second vertical layer. In the illustrative example of Figures 2(a)-(c), N2=8 (there are four sides, each comprising two PEBBs). In the sectional view of Figure 2(c) the second vertical level is defined by the section taken along the line A-A, a top view of which is schematically illustrated in Figure 2(a) which also shows the section C-C at which the sectional view of Figure 2(c) is illustrated.

A cooling liquid, in Figure 2(c) schematically illustrated by its flow 17, is arranged to, by thermal driven circulation generated by the PEBBs 12, flow along a liquid flow path in a direction to first cool the PEBBs of the first vertical level and then to cool the PEBBs of the second vertical level, thereby providing uneven temperature distribution of the cooling liquid and uneven cooling of the PEBBs. A method for cooling PEBBs comprises cooling (in a step S106) the PEBBs by providing such a cooling liquid.

Currently the common design practice is to size the PEBBs for the worst case ambient temperature which exists in the top level of the chamber structure. The proposed arrangements may thus be found very useful when increase in converter current rating is required based on existing PEBB and module design. PEBBs paralleling at the top vertical levels of the chamber structure will be allowed to push more current through the semiconductor modules, thus enabling the higher output power at the given qualified PEBB design.

According to an embodiment, the PEBBs on at least one vertical layer are connected in parallel. Further, the PEBBs of each vertical layer may be connected in parallel such that the same current flows through the PEBBs of each vertical layer and thus the same total heat is dissipated in the PEBBs of each layer. This further improves the generation of a positive temperature gradient of the cooling liquid from the bottom to the top, thus enabling an improved thermal driven circulation of the cooling fluid. According to the illustrative example of Figures 2(a)-(c), the cooling liquid is first heated by the PEBBs of the first vertical level (thus cooling the PEBBs of the first vertical level) and then heated by the PEBBs of the second vertical level (thus cooling the PEBBs of the second vertical level). Thus, preferably the arrangement is arranged such that, when in use, the second vertical level is higher up than the first vertical level.

The arrangement may comprise vertical walls 16 at which the PEBBs are arranged. The vertical walls 16 vertically enclose a chamber 15. This chamber may be denoted a first chamber. The cooling liquid inside the chamber 15 flows in a direction from the first vertical layer towards the second vertical layer.

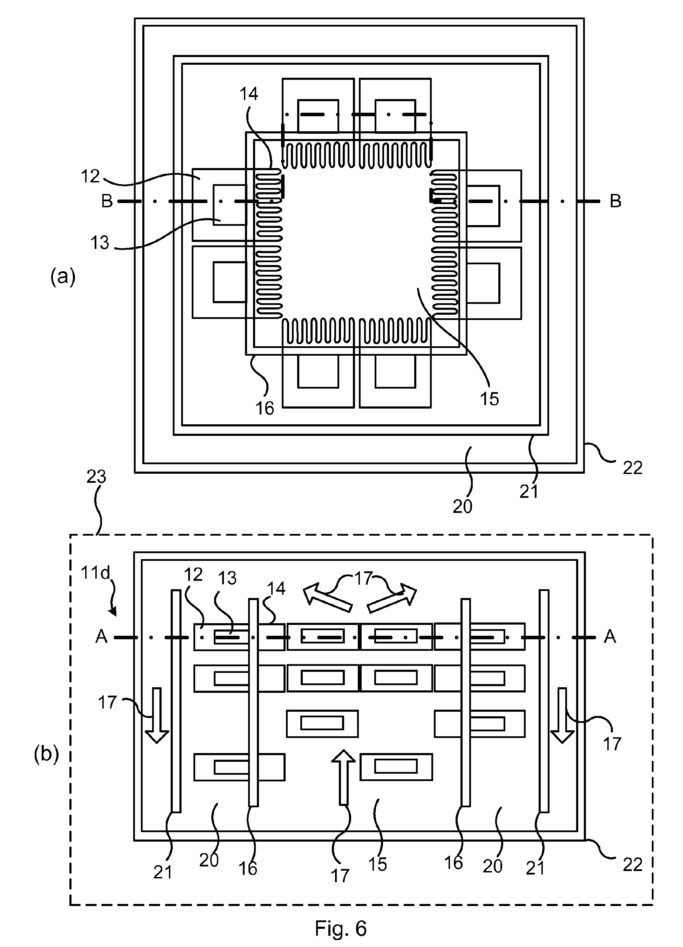

According to embodiments the arrangement comprises at least one further chamber. Figures 6(a) and 6(b) schematically illustrate such an arrangement 11d. In Figure 6(b) the arrangement 11d is illustrated as part of a subsea power conversion unit 23. Figure 6(a) schematically illustrates a top view taken at the section A-A in Figure 6(b) and Figure (6b) schematically illustrates a sectional view taken at the section B-B in Figure 6(a). The first chamber 15 is arranged inside an outer chamber 20 vertically enclosed by vertical walls 21. The first chamber 15 may thus define an inner chamber. The semiconductor modules may then be arranged between the walls 16 of the inner chamber and walls 21 of the outer chamber. The semiconductor modules may thus be arranged outside the inner chamber and inside the outer chamber. Due to the thermal driven circulation generated by the PEBBs the direction of the flow of the cooling liquid outside the outer chamber is opposite the direction of the flow of the cooling liquid inside the inner chamber. The outer chamber may be arranged in a water-sealed tank 22.

Each PEBB may comprise a heat-sink 14. Each heat-sink may be arranged in the liquid flow path. In embodiments where the arrangement comprises a first chamber the heat-sinks are arranged inside the first chamber.

Embodiments relating to further details of the arrangement will now be disclosed in turn.

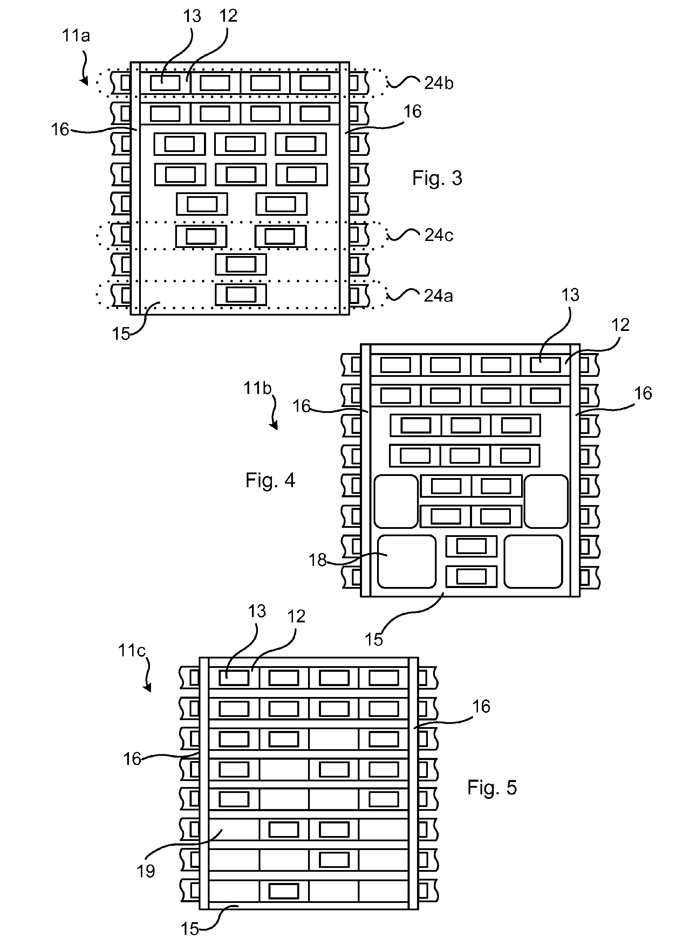

The arrangement may further comprise at least one intermediate vertical level 24c comprising N3 PEBBs, wherein N3=N1, or N3=N2, or N1<N3<N2. Hence, according to an embodiment the arrangement comprises at least three vertical levels 24a, 24b, 24c. The at least one intermediate vertical level is placed between the first vertical level and the second vertical level. Figures 3, 4, and 5 are sectional views of arrangement 11a, 11b, and 11c, respectively, comprising eight vertical levels, where each vertical level comprises a number of PEBBs 12 comprising semiconductor modules 13. In the illustrative examples of Figures 3-5 there are thus six intermediate vertical levels (one of which is denoted by reference numeral 24c); a first intermediate vertical level comprising 4 PEBBs (there are four sides defined by walls 16 enclosing a chamber 15, see above), a second intermediate vertical level comprising 8 PEBBs, a third intermediate vertical level comprising 8 PEBBs, a fourth intermediate vertical level comprising 12 PEBBs, a fifth intermediate vertical level comprising 12 PEBBs, and a sixth intermediate vertical level comprising 16 PEBBs. A concept for realization may thus comprise a different number of modules in different layers of the chamber structure. The lowest layer has the lowest number of PEBBs and the number of PEBBs grows with layers further up. Since the modules are ever more de-rated going from bottom to top, the effect of worse cooling in hotter cooling liquid is compensated and the junction temperatures are equalized.

The volume efficiency could be improved by placing further elements at the free locations in lower levels, for example braking resistors. According to an embodiment the arrangement thus further comprises heat-dissipating equipment arranged in the liquid flow path. This is illustrated in Figure 4. Figure 4 schematically illustrates an arrangement 11b similar to that of Figure 3. In relation thereto the arrangement 11b in Figure 4 further comprises four examples of additional heat-dissipating equipment 18. As considerable heat sources, these elements may have a positive impact on establishing a convective flow of the cooling liquid.

Figure 5 gives an example of a modular approach where at each side of the chamber PEBBs or modules can be arranged in a grid pattern. The grid pattern is formed by cells, where each cell is arranged to receive one PEBB. The placement of the cells in the grid pattern may follow that of so-called square tiling and thus the cells may form a square grid. Figure 5 schematically illustrates an arrangement 11c similar to that of Figure 3. In relation thereto the PEBBs of the arrangement 11c in Figure 5 are placed in a grid. According to an embodiment the PEBBs on each level are thus placed in a grid pattern. Depending on the desired power rating (which is defined by the number of "active cells", i.e., cells containing PEBBs), not all grid places are filled up with PEBBs but some places are left empty or are filled with auxiliary equipment that produces less heat (defining so-called "passive cells" 19). The lifetime-enhancing effect of distributed heating may be achieved whilst space is used efficiently in the arrangement, which may be used in a subsea container. In case of a subsea power conversion unit utilizing such a modular multilevel converters (MMC) topology, control freedoms of the MMC topology can be utilized to reduce of the switching frequency or operating voltage of modules with poor cooling and increase switching frequency and voltage of modules with good cooling. MMCs may be particularly suitable for subsea use, since they are reliable. MMCs are configured to provide redundant power modules or power cells. It is thus possible to arrange the power modules in rows and columns (stacks). The cooling arrangement may therefore be adapted to the arrangement of MMC power modules. It is possible to adapt the cooling arrangement to the modularity of the cells, meaning that the cooling arrangement as a whole is modular. Thus the modules or stackable electric modules have a multilevel topology and the electric converter system may be a multilevel converter system.

The speed of the liquid flow in the upper part of the arrangement may be increased by reducing the free cross sectional area where liquid can flow. In turn, this may be achieved by changing the geometry of the arrangement or filling it with more PEBBs or other components. According to an embodiment the arrangement thus further comprises means for changing the liquid flow path.

By inserting flow-breakers in the middle and upper part of the arrangement, higher turbulence could be created for better heat transfer in the middle and upper part of the arrangement. According to an embodiment the heat-sinks of the PEBBs of at least the second vertical level thus comprises flow breakers or channels.

In summary, there has been disclosed an arrangement that can be embodied as, or being part of, an electrical and/or electronic system contained in a water tight vessel filled with a cooling liquid, where cooling of modules inside the tank are achieved by a thermal driven circulation of the cooling liquid, resulting in an uneven temperature distribution of the cooling liquid inside the tank and uneven cooling of modules arranged in the tank. This uneven temperature distribution and/or uneven cooling may be compensated by utilizing unit control freedoms to "move" losses from PEBBs with poor cooling to PEBBs with better cooling. Any kind of geometric arrangement of the PEBBs with the goal to equalize the cooling performance can be used. Any kind of further heat dissipating elements may be used in the space not occupied by PEBBs may improve the volume efficiency of the arrangement and may help establishing a stable natural convective cooling flow. The flow of the cooling liquid may be increased by local geometric changes of the liquid path in order to (improve or) compensate for reduced the cooling performance due to an increased temperature of the cooling liquid along the liquid flow path. The heat transfer from the PEBBs to the cooling liquid may be improved in the middle to upper part of the chamber by flow breakers or channels in the heat sinks of the PEBBs. The concepts as herein disclosed could either be realized on the PEBB cell level or on the power semiconductor module level inside the PEBB.

The invention has mainly been described above with reference to a few embodiments. However, as is readily appreciated by a person skilled in the art, other embodiments than the ones disclosed above are equally possible within the scope of the invention, as defined by the appended patent claims. Further, as the skilled person understands, any feature associated with the herein disclosed arrangements for cooling power electronics building blocks may also be associated with the herein disclosed method for cooling power electronics building blocks, where terms such as "comprising", "including", etc., may be replaced by the term "providing", etc.

## Claims

1. An arrangement (11, 11a, 11b, 11c, 11d) for cooling power electronics building blocks, PEBBs, (12) wherein each PEBB comprises a semiconductor module (13), the arrangement comprising:
a first vertical level (24a) comprising N1 PEBBs;
a second vertical level (24b) comprising N2 PEBBs, where N2>N1; and
a cooling liquid (17), wherein thermal driven circulation generated by the PEBBs causes the cooling liquid to flow along a liquid flow path in a direction to first cool the PEBBs of the first vertical level and then to cool the PEBBs of the second vertical level, thereby providing uneven temperature distribution of the cooling liquid and uneven cooling of the PEBBs.

2. The arrangement according to claim 1, further comprising at least one intermediate vertical level (24c) comprising N3 PEBBs placed between the first vertical level and the second vertical level, wherein N3=N1, or N3=N2, or N1<N3<N2.

3. The arrangement according to claim 1, wherein the arrangement is arranged such that, when in use, the second vertical level is higher up than the first vertical level.

4. The arrangement according to claim 1, further comprising heat-dissipating equipment (18) arranged in the liquid flow path.

5. The arrangement according to claim 1,wherein PEBBs on at least one vertical layer are connected in parallel.

6. The arrangement according to claim 1, wherein the PEBBs on each level are placed in a grid pattern.

7. The arrangement according to claim 1, wherein the PEBBs are arranged at vertical walls (16) vertically enclosing a first chamber (15).

8. The arrangement according to claim 7, wherein the first chamber is an inner chamber, the inner chamber being arranged inside an outer chamber (20).

9. The arrangement according to claim 8, wherein the semiconductor modules are arranged outside the inner chamber and inside the outer chamber.

10. The arrangement according to claim 8 or 9, wherein the outer chamber is arranged in a water-sealed tank (22).

11. The arrangement according to claim 1, wherein each PEBB further comprises a heat-sink (14), each heat-sink being arranged in the liquid flow path.

12. The arrangement according to claim 11, wherein the heat-sinks of the PEBBs of at least the second vertical level comprises flow breakers or channels.

13. The arrangement according to claim 11 or 12, and 7, wherein the heat-sinks are arranged inside the first chamber.

14. A subsea power conversion unit (23) comprising an arrangement according to claim 1.

15. A method for cooling power electronics building blocks, PEBBs, (12) wherein each PEBB comprises a semiconductor module (13), the method comprising:
providing (S102) a first vertical level (24a) comprising N1 PEBBs;
providing (S104) a second vertical level (24a) comprising N2 PEBBs, where N2>N1; and
cooling (S104) the PEBBs by providing a cooling liquid (17), wherein thermal driven circulation generated by the PEBBs causes the cooling liquid to flow along a liquid flow path in a direction passing the PEBBs of the first vertical level before the PEBBs of the second vertical level, thereby providing uneven temperature distribution of the cooling liquid and uneven cooling of the PEBBs.

## Amended claims

### Amended claims in accordance with Rule 137(2) EPC.

1. An arrangement (11, 11a, 11b, 11c, 11d) for cooling power electronics building blocks, PEBBs, (12) contained in a water-sealed tank (22) filled with a cooling liquid (17), wherein each PEBB comprises a semiconductor module (13), the arrangement comprising:
a first level (24a) of PEBBs and a second level (24b) of PEBBs vertically distributed;
wherein in use heat generated by the PEBBs cases causes the cooling liquid to flow along a liquid flow path in a direction from the bottom of the water sealed tank (22) towards the top of the water sealed tank (22) and thus to cool the first level of PEBBs and the second level of PEBBs;
**characterised in**
the first level (24a) comprising N1 PEBBs;
the second level (24b) comprising N2 PEBBs, where N2>N1; and
the first level of PEBBs and the second level of PEBBs thereby providing uneven temperature distribution of the cooling liquid and enabling an improved thermal driven circulation of the cooling liquid.

2. The arrangement according to claim 1, further comprising at least one intermediate level (24c) comprising N3 PEBBs placed between the first level and the second level, wherein N3=N1, or N3=N2, or N1<N3<N2.

3. The arrangement according to claim 1, wherein the arrangement is arranged such that, when in use, the second level is higher up than the first level.

4. The arrangement according to claim 1, further comprising heat-dissipating equipment (18) arranged in the liquid flow path.

5. The arrangement according to claim 1, wherein PEBBs on at least one level are connected in parallel.

6. The arrangement according to claim 1, wherein the PEBBs on each level are placed in a grid pattern.

7. The arrangement according to claim 1, wherein the PEBBs are arranged at vertical walls (16) vertically enclosing a first chamber (15).

8. The arrangement according to claim 7, wherein the first chamber is an inner chamber, the inner chamber being arranged inside an outer chamber (20).

9. The arrangement according to claim 8, wherein the semiconductor modules are arranged outside the inner chamber and inside the outer chamber.

10. The arrangement according to claim 8 or 9, wherein the outer chamber is arranged in the water-sealed tank (22).

11. The arrangement according to claim 1, wherein each PEBB further comprises a heat-sink (14), each heat-sink being arranged in the liquid flow path.

12. The arrangement according to claim 11, wherein the heat-sinks of the PEBBs of at least the second level comprises flow breakers or channels.

13. The arrangement according to claim 11 or 12, and 7, wherein the heat-sinks are arranged inside the first chamber.

14. A subsea power conversion unit (23) comprising an arrangement according to claim 1.

15. A method for cooling power electronics building blocks, PEBBs, (12) wherein each PEBB comprises a semiconductor module (13), the method comprising:
providing (S102, S104) a first level (24a) of PEBBs and a second level (24b) of PEBBs vertically distributed in a water-sealed tank (22);; and
cooling (S106) the PEBBs by filling the water sealed tank with a cooling liquid (17), wherein heat generated by the PEBBs cases causes the cooling liquid to flow along a liquid flow path in a direction from the bottom of the water sealed tank (22) towards the top of the water sealed tank (22) and thus to cool the first level of PEBBs and the second level of PEBBs;
**characterised in**
the first level (24a) comprising N1 PEBBs;
the second level (24b) comprising N2 PEBBs, where N2>N1; and
the first level of PEBBs and the second level of PEBBs providing uneven temperature distribution of the cooling liquid and enabling an improved thermal driven circulation of the cooling liquid.
